(19) Europäisches Patentamt / European Patent Office / Office européen des brevets

(11) **EP 3 664 141 B1**

(12) **FASCICULE DE BREVET EUROPEEN**

(45) Date de publication et mention
de la délivrance du brevet:
**25.08.2021   Bulletin 2021/34**

(51) Int Cl.:
***H01L 27/146*** *(2006.01)*

(21) Numéro de dépôt: **19212619.1**

(22) Date de dépôt: **29.11.2019**

(54) **MATRICE DE PHOTO-DÉTECTEURS À ABSORPTION PÉRIPHÉRIQUE MUNIE DE STRUCTURES DE FOCALISATION**

MATRIX VON PERIPHEREN ABSORPTIONS-FOTODETEKTOREN MIT FOKUSSIERUNGSSTRUKTUREN

PERIPHERAL ABSORPTION PHOTOSENSOR ARRAY  WITH FOCUSING STRUCTURES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **03.12.2018   FR 1872252**

(43) Date de publication de la demande:
**10.06.2020   Bulletin 2020/24**

(73) Titulaire: **Commissariat à l'énergie atomique et aux énergies alternatives
75015 Paris (FR)**

(72) Inventeurs:
• **BADANO, Giacomo
  38054 GRENOBLE CEDEX 09 (FR)**
• **LOBRE, Clément
  38054 GRENOBLE CEDEX 09 (FR)**

(74) Mandataire: **Brevalex
56, Boulevard de l'Embouchure
B.P. 27519
31075 Toulouse Cedex 2 (FR)**

(56) Documents cités:
**US-A1- 2012 273 907     US-A1- 2013 003 204
US-A1- 2013 135 502**

**Description**

**DOMAINE TECHNIQUE**

L'invention se rapporte au domaine de la détection et/ou la mesure de rayonnement électromagnétique. Elle concerne plus particulièrement un dispositif de photo-détection comportant une matrice de pixels, et dans lequel chaque pixel comporte une photodiode dont la région d'absorption s'étend en totalité ou presque dans un volume entourant une région centrale dudit pixel.

**ÉTAT DE LA TECHNIQUE ANTÉRIEURE**

On connaît dans l'art antérieur des matrices de photodiodes dans lesquelles chaque photodiode a sa région d'absorption qui s'étend en totalité ou presque dans un volume entourant une région centrale du pixel. Ce volume a par exemple la forme d'un tore ouvert (tube cylindrique recourbé sur lui-même). Ce type de géométrie permet de limiter la diaphonie, ou cross-talk, c'est-à-dire la détection par une photodiode d'un porteur généré par l'absorption d'un photon dans une photodiode voisine. Une telle matrice de photodiodes comporte classiquement une couche active en matériau semi-conducteur, dans laquelle s'étendent des caissons dopés qui définissent chacun une jonction PN. Chaque caisson dopé correspond donc à une photodiode. Les caissons dopés s'étendent chacun sur toute l'épaisseur de la couche active ou presque. Dans chaque photodiode, la région d'absorption s'étend alors, en totalité ou presque, dans un volume en forme de tore entourant le caisson dopé. On rappelle que la région d'absorption d'une photodiode désigne la région en matériau semi-conducteur dans laquelle des photons incidents génèrent des paires électrons-trous à l'origine de l'émission d'un courant électrique dans la photodiode.

Un exemple d'une telle matrice de photodiodes est décrit par Schaake H. F. & al., dans l'article « High Operating Temperature MWIR detectors », Proceedings of SPIE, Vol. 7608, janvier 2010. Dans cet article, il est décrit des photodiodes dites intégrées verticalement, avec un trou traversant, ou via, qui traverse la couche active de part en part en passant par le centre du caisson dopé. Ici, la région d'absorption s'étend entièrement dans un volume entourant latéralement le via.

Un autre exemple d'une telle matrice de photodiodes est décrit dans le brevet FR 2 983 352. Ce brevet décrit des photodiodes formées dans une couche active en matériau semi-conducteur, avec chacune un caisson central dopé P, entouré par une région d'absorption dopée N, elle-même entourée par une région de séparation fortement dopée N. Le caisson dopé peut s'étendre sur toute l'épaisseur de la couche active. Dans ce cas, la région d'absorption s'étend entièrement dans un volume entourant latéralement le caisson dopé. En variante, le caisson dopé ne s'étend pas selon toute l'épaisseur de la couche active. Dans ce cas, la région d'absorption s'étend presque entièrement dans un volume ouvert au centre entourant latéralement le caisson dopé, et dépasse également sous le caisson dopé. US 2012/273907 décrit un autre exemple d'un dispositif de photo-détection.

Un objectif de la présente invention est d'améliorer la sensibilité d'un dispositif de photo-détection comportant une matrice de pixels dans laquelle chaque pixel comporte une photodiode dont la région d'absorption s'étend en totalité ou en majeure partie dans un volume entourant une région centrale dudit pixel.

**EXPOSÉ DE L'INVENTION**

Cet objectif est atteint avec un dispositif de photo-détection comportant une matrice de pixels, les pixels comprenant chacun une photodiode dont la région d'absorption s'étend en totalité ou en majeure partie dans un volume entourant une région centrale du pixel.

Selon l'invention, chaque pixel comporte en outre un élément de focalisation, pour focaliser sur la région d'absorption de la photodiode appartenant audit pixel un rayonnement lumineux arrivant à incidence sensiblement normale sur ce même pixel.

Les éléments de focalisation sont constitués d'un ensemble de structures réfractives. Chaque structure réfractive est formée par une première pyramide tronquée et munie d'un évidement. Ladite première pyramide a sa base parallèle au plan de la matrice de pixels, et située du côté de la structure réfractive faisant face aux photodiodes. L'évidement a la forme d'une seconde pyramide entière ou tronquée. Ladite seconde pyramide a sa base qui s'étend parallèle au plan de la matrice de pixels, du côté de la structure réfractive qui est opposé aux photodiodes.

En outre, les angles à la base $\varphi_i$ des premières pyramides et des secondes pyramides vérifient chacun :
[Math 1]

$$2\varphi_i - \sin^{-1}\left(\frac{n_0}{n_1}\sin(\varphi_i)\right) < \frac{\pi}{2} \qquad (1)$$

avec $n_0$ l'indice optique d'un milieu environnant entourant les structures réfractives du côté opposé aux photodiodes, et $n_1$ un indice optique desdites structures réfractives.

Dans tout le texte, un rayonnement lumineux arrivant à incidence sensiblement normale sur un pixel est orienté selon un axe incliné d'un angle inférieur ou égal à 7° relativement à la normale au plan de la matrice de pixels.

Les photodiodes du dispositif selon l'invention ont chacune leur région d'absorption qui s'étend en totalité ou en majeure partie dans un volume entourant latéralement une région centrale du pixel. En d'autres termes, dans chaque pixel, plus de la moitié voire plus de 80% du volume de la région d'absorption s'étend dans ledit volume entourant latéralement une région centrale du pixel. Dit encore autrement, les photodiodes ont chacune leur région d'absorption qui s'étend principalement dans une zone périphérique du pixel. Deux exemples de photodiodes présentent cette caractéristique sont décrits en introduction, sans que l'invention ne soit limitée à ces exemples.

Les éléments de focalisation peuvent également être nommés « éléments de collecte de photons ». Ils sont aptes à dévier, vers les régions d'absorption respectives des photodiodes, des rayonnements lumineux arrivant à incidence sensiblement normale sur la matrice de pixels.

Les éléments de focalisation sont constitués ensemble par les structures réfractives. Les structures réfractives ont chacune une forme définie par une première pyramide tronquée pourvue d'un évidement en forme de seconde pyramide entière ou tronquée. La forme des éléments de focalisation est donc définie par une série de faces planes, ce qui facilite leur fabrication. Les éléments de focalisation se distinguent en particulier de microlentilles, lesquelles ont des faces incurvées plus difficiles à réaliser.

Les angles à la base des premières pyramides (respectivement des secondes pyramides) désignent chacun un angle formé entre la base de ladite pyramide et une face latérale respective de la même pyramide. On peut montrer que lorsque la condition de l'équation (1) est vérifiée, il est possible de concentrer sous la structure réfractive, dans un volume entourant latéralement une région centrale du pixel, l'énergie d'un faisceau lumineux arrivant à incidence sensiblement normale sur la matrice de pixels. Là encore, un faisceau lumineux arrivant à incidence sensiblement normale sur la matrice de pixels, ou sur un pixel, est un faisceau orienté selon un axe incliné d'un angle inférieur ou égal à 7° relativement à la normale au plan de la matrice de pixels. Dans tout le texte, on considère en outre un faisceau lumineux arrivant sur la matrice de pixel du côté des éléments de focalisation. Il est ainsi possible de concentrer l'énergie d'un tel faisceau lumineux dans des volumes qui coïncident avec les régions d'absorption des photodiodes. Quelle que soit sa position d'incidence sur le pixel, un rayonnement lumineux arrivant à incidence sensiblement normale sur ledit pixel est alors dévié vers la région d'absorption du même pixel, où il peut donner naissance à des porteurs de charge aptes à générer un courant. En particulier, un rayonnement lumineux arrivant sur le pixel au regard d'une région centrale dudit pixel est dévié vers la périphérie du pixel, où se trouve la région d'absorption. Ainsi, bien que ladite région centrale soit occupée par des éléments qui ne permettent pas la détection de photons (via ou caisson dopé, par exemple), tous les photons sur la matrice de pixels peuvent être détectés. Le rendement de capture des photodiodes, et donc la sensibilité du dispositif selon l'invention, sont ainsi améliorés. Le rendement de capture désigne le rapport du nombre de charges traversant la jonction PN sur le nombre de photons incidents sur le pixel correspondant. Une solution évidente pour améliorer la sensibilité aurait pu consister plutôt à réduire le volume occupé par le via ou le caisson dopé, au centre du pixel. Bien qu'elle semble a priori plus simple, cette solution s'avère technologiquement plus difficile à réaliser.

De préférence, la base de la première pyramide tronquée est un carré ou un rectangle.

Chacune des première et seconde pyramides est avantageusement une pyramide droite.

De préférence, une hauteur h de chacune desdites structures réfractives vérifie :

[Math 2]

$$h \geq \frac{\lambda_{moy}}{2n_1}$$

avec $n_1$ l'indice optique desdites structures réfractives et $\lambda_{moy}$ la longueur d'onde centrale d'une plage spectrale de détection du dispositif de photo-détection.

Les angles à la base de chacune desdites premières pyramides et secondes pyramides sont avantageusement compris chacun entre 50° et 60°.

L'indice optique desdites structures réfractives est de préférence inférieur ou égal à 1,7.

Dans chaque structure réfractive, les faces latérales de la seconde pyramide sont avantageusement parallèles deux à deux aux faces latérales de la première pyramide.

Dans chaque structure réfractive, la première pyramide est tronquée de préférence selon un plan parallèle au plan de la matrice de pixels.

Dans chaque structure réfractive, l'évidement a avantageusement la forme d'une seconde pyramide entière qui s'étend jusqu'à la base de la première pyramide tronquée.

De manière avantageuse, dans chaque structure réfractive, les faces latérales de la première pyramide tronquée et les faces latérales de l'évidement se rejoignent deux à deux du côté opposé aux photodiodes.

En variante, dans l'une au moins des structures réfractives, les faces latérales de la première pyramide tronquée et les faces latérales de l'évidement peuvent être séparées deux à deux par une surface supérieure de la structure réfractive, du côté opposé aux photodiodes.

Selon un premier mode de réalisation, chaque structure réfractive s'étend sur un unique pixel.

Dans ce premier mode de réalisation, et de manière avantageuse, dans l'une au moins des structures réfractives, les faces latérales de la première pyramide tronquée et les faces latérales de l'évidement sont séparées deux à deux par une surface supérieure de la structure réfractive située du côté opposé aux photodiodes, et chaque point de ladite surface supérieure est espacé de la face inférieure de la structure réfractive, d'une distance $d_1(x, y)$ supérieure ou égale à $d_{1\_lim}$ et également sensiblement égale à $d_{1\_lim}$ à plus ou moins 10% près, avec :

[Math 3]

$$d_{1\_lim} = \frac{P}{4} * \frac{\tan(\varphi_j)}{1 + \tan(\varphi_j) * \tan(\varphi_j - \theta)}$$

avec P un pas de pixel de la matrice de pixels ;
$\varphi_j$ un angle à la base de ladite première pyramide ; et
$\theta$ l'angle de réfraction, dans la structure réfractive d'un rayonnement lumineux arrivant à incidence normale sur la matrice de pixels.

Selon un deuxième mode de réalisation, chaque structure réfractive s'étend à cheval sur plusieurs pixels voisins.

Dans ce deuxième mode de réalisation, et de manière avantageuse, dans l'une au moins des structures réfractives, les faces latérales de la première pyramide tronquée et les faces latérales de l'évidement sont séparées deux à deux par une surface supérieure de la structure réfractive située du côté opposé aux photodiodes, et chaque point de ladite surface supérieure est espacé de la face inférieure de la structure réfractive, d'une distance $d_2(x, y)$ strictement inférieure à :

[Math 4]

$$\frac{P}{2} * \frac{\tan(\varphi_j)}{1 + \tan(\varphi_j) * \tan(\varphi_j - \theta)}$$

avec P un pas de pixel de la matrice de pixels ;
$\varphi_j$ un angle à la base de ladite première pyramide ; et
$\theta$ l'angle de réfraction, dans la structure réfractive, d'un rayonnement lumineux arrivant à incidence normale sur la matrice de pixels.

Le dispositif selon l'invention peut comporter une couche antireflet entre les structures réfractives et les photodiodes.

L'invention concerne également un procédé de réalisation d'un dispositif selon l'invention, dans lequel les angles à la base des premières pyramides et des secondes pyramides sont compris chacun entre 50° et 60°, le procédé comportant les étapes suivantes :

- dépôt d'une couche d'impression de manière à recouvrir une matrice de photodiodes, lesdites photodiodes ayant chacune leur région d'absorption qui s'étend en totalité ou en majeure partie dans un volume entourant une région centrale du pixel ; et
- impression de la couche d'impression pour former les structures réfractives, en utilisant un moule en silicium que l'on presse contre la couche d'impression.

**BRÈVE DESCRIPTION DES DESSINS**

La présente invention sera mieux comprise à la lecture de la description d'exemples de réalisation donnés à titre purement indicatif et nullement limitatif, en faisant référence aux dessins annexés sur lesquels :

[Fig. 1A] et

[Fig. 1B] illustrent de façon schématique, respectivement selon une vue en perspective et selon une vue en coupe, un premier mode de réalisation d'un dispositif de photo-détection selon l'invention ;

[Fig. 2] illustre de façon schématique une limite supérieure d'un angle à la base de la structure réfractive d'un dispositif de photo-détection selon l'invention ;

[Fig. 3] illustre une répartition du champ électromagnétique sous la structure réfractive d'un dispositif de photo-détection selon le premier mode de réalisation de l'invention, en fonction de la valeur d'un angle à la base de ladite structure ;

[Fig. 4] illustre des courbes d'absorption dans un pixel d'un dispositif de photo-détection selon le premier mode de réalisation de l'invention, en fonction de la valeur d'un angle à la base de la structure réfractive correspondante, et pour différentes valeurs de l'indice optique de ladite structure ;

[Fig. 5A] et

[Fig. 5B] illustrent de façon schématique un deuxième mode de réalisation d'un dispositif de photo-détection selon l'invention ;

[Fig. 6A] et

[Fig. 6B] illustrent de façon schématique un troisième mode de réalisation d'un dispositif de photo-détection selon l'invention ;

[Fig. 7] illustre de façon schématique un quatrième mode de réalisation d'un dispositif de photo-détection selon l'invention ;

[Fig. 8A] et

[Fig. 8B] illustrent respectivement, selon des vues en coupe, des vues détaillées de deux variantes du premier mode de réalisation d'un dispositif de photo-détection selon l'invention ; et

[Fig. 9] illustre un procédé de fabrication d'un moule utilisé pour réaliser un dispositif de photo-détection selon l'invention.

## EXPOSÉ DÉTAILLÉ DE MODES DE RÉALISATION PARTICULIERS

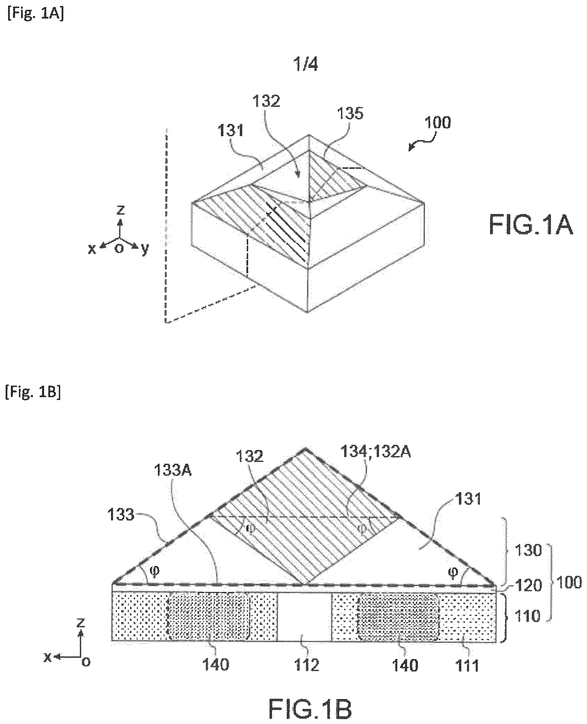

Les figures 1A et 1B illustrent de façon schématique un dispositif de photo-détection selon un premier mode de réalisation de l'invention, respectivement selon une vue en perspective et selon une vue en coupe dans un plan parallèle au plan (xOz) d'un repère orthonormé (Oxyz).

Le dispositif de photo-détection selon l'invention est formé d'une pluralité de pixels, repartis selon deux directions de l'espace en une matrice de pixels. Les deux directions de l'espace définissent le plan (Oxy) de la matrice de pixels. Ce plan est parallèle à une face supérieure ou inférieure de la matrice de pixels. Pour des raisons de clarté, on a représenté un unique pixel 100 du dispositif de photo-détection.

Selon l'invention, le dispositif de photo-détection comporte, superposés dans cet ordre le long de l'axe (Oz) :

- un étage 110 comportant des photodiodes,
- une couche antireflet 120, optionnelle, et
- un étage 130 comportant des éléments de focalisation, pour focaliser sur les régions d'absorption des photodiodes un rayonnement lumineux arrivant à incidence sensiblement normale sur la matrice de pixels.

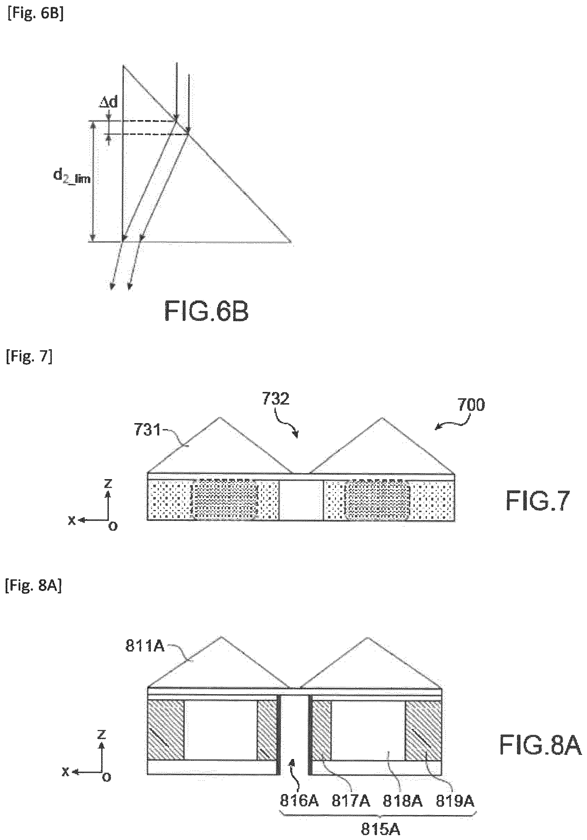

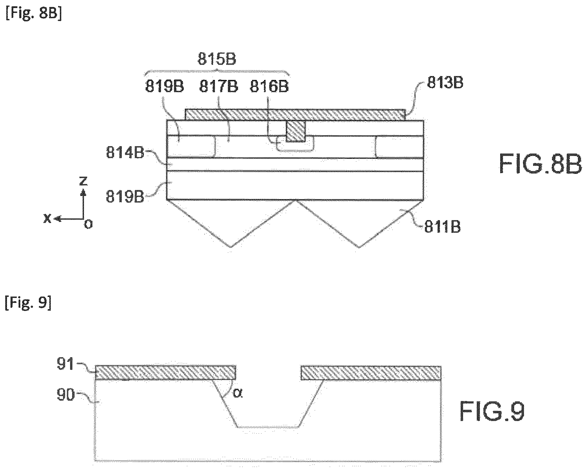

Dans l'étage 110, chacune des photodiodes s'étend dans un pixel respectif de la matrice de pixels. Chaque photodiode comporte notamment une jonction PN, et une région d'absorption dans laquelle des photons incidents génèrent des paires électrons-trous à l'origine de l'émission d'un courant électrique au niveau de la jonction PN. La région d'absorption s'étend en totalité ou presque dans un volume 111 entourant latéralement une région centrale 112 du pixel 100. Ladite région centrale 112 est centrée sur le pixel 100, et s'étend sur toute la hauteur de l'étage 110. De telles photodiodes sont décrites plus en détail dans la suite, en référence aux figures 8A et 8B.

La couche antireflet 120 permet de protéger les photodiodes, et de fournir une interface non-réfléchissante entre l'étage 110 et l'étage 130. Elle présente généralement un indice optique compris entre 2 et 3, par exemple 2,2. Elle présente une épaisseur de l'ordre de $\lambda_{moy}/4n_{ar}$, avec $\lambda_{moy}$ la longueur d'onde centrale d'une plage de longueurs d'onde que les photodiodes sont aptes à détecter et $n_{ar}$ l'indice optique de ladite couche. Cette épaisseur est comprise par exemple entre 1 µm et 3 µm, par exemple 2,2 µm. Elle est constituée par exemple de sulfure de zinc. Une couche de substrat résiduel, non représentée, peut s'étendre entre la couche antireflet 120 et l'étage 110 comportant des photodiodes. L'épaisseur de la couche de substrat résiduel est inférieure à 5 µm.

Dans l'étage 130, chacun des éléments de focalisation s'étend dans un pixel respectif de la matrice de pixels. Les éléments de focalisation s'étendent du côté de la matrice de pixels qui reçoit un rayonnement à détecter. Dans chaque pixel, l'élément de focalisation est apte à focaliser, dans la région d'absorption de la photodiode, un rayonnement lumineux arrivant sur le dispositif de photo-détection selon un axe sensiblement normal au plan de la matrice de pixels.

Chaque élément de focalisation est donc apte à focaliser ledit rayonnement lumineux dans le volume 111 dudit pixel. Les éléments de focalisation sont formés ensemble par des structures réfractives 131.

Ici, chaque pixel comporte une structure réfractive 131 respective. Dans chaque pixel, la structure réfractive 131 et la photodiode sont centrées sur le pixel.

Chaque structure réfractive 131 s'étend dans un volume délimité par les parois d'une première pyramide, tronquée, et munie d'un évidement 132 qui s'étend jusqu'à la base de ladite première pyramide.

La figure 1B est une vue en coupe du pixel 100, dans un plan (xOz) passant par le centre du pixel 100. La figure 1B montre notamment la structure réfractive 131 du pixel 100, ainsi que la première pyramide 133 et la surface de troncature 134 définissant la première pyramide tronquée.

La première pyramide 133 a sa base 133A qui s'étend du côté de l'étage 110 comportant des photodiodes, parallèle au plan (Oxy) de la matrice de photodiodes. La base 133A est de forme carrée ou rectangulaire, selon que les pixels de la matrice de photodiodes soient répartis selon un maillage carré ou rectangulaire. Les côtés de la base sont orientés parallèles à l'axe (Ox), respectivement parallèles à l'axe (Oy). La première pyramide 133 est une pyramide droite, ce qui signifie qu'un axe reliant le centre de la base et l'apex est orthogonal à ladite base.

La surface de troncature 134 s'étend à distance de la base 133A, sans passer par cette dernière. La surface de troncature 134 s'étend ici dans un plan parallèle au plan de la matrice de pixels.

L'évidement 132 a la forme d'une seconde pyramide, entière ou tronquée. Dans l'exemple des figures 1A et 1B, il s'agit d'une seconde pyramide entière, l'évidement 132 ayant donc une forme pointue au fond. La seconde pyramide a sa base 132A qui s'étend parallèle au plan (Oxy) de la matrice de photodiodes. Cette base 132A s'étend du côté de la structure réfractive opposé à l'étage 110 comportant des photodiodes. La seconde pyramide forme ainsi une pyramide renversée.

La base 132A de la seconde pyramide est de forme carrée ou rectangulaire. Les côtés de la base 132A sont parallèles deux à deux aux côtés de la base 133A. En d'autres termes, chaque côté de la base 132A est parallèle à un côté respectif de la base 133A. La seconde pyramide est également une pyramide droite.

Les faces latérales de la première pyramide tronquée et les faces latérales de l'évidement en forme de seconde pyramide se rejoignent deux à deux en formant des arêtes, du côté opposé à l'étage 110 comportant les photodiodes.

Dans l'exemple représenté aux figures 1A et 1B, les faces latérales de la seconde pyramide sont parallèles deux à deux avec les faces latérales de la première pyramide. En d'autres termes, chaque face latérale de la seconde pyramide est parallèle à une face latérale respective de la première pyramide. Sur la figure 1A, un couple d'une face latérale de la première pyramide et une face latérale de la seconde pyramide parallèles entre elles est représenté hachuré. On remarque que les faces latérales parallèles deux à deux ne sont pas situées directement au regard l'une de l'autre. Les faces latérales d'une pyramide désignent ses faces triangulaires, distinctes de la base. La seconde pyramide correspond alors à la forme complémentaire de la première pyramide tronquée, formant avec cette dernière une pyramide entière.

Ici, la première pyramide 133 est tronquée à mi-hauteur. Selon une vue en coupe, la structure réfractive 131 a alors la forme de deux triangles isocèles (voir figure 1B).

Des angles à la base de la première pyramide, sont les angles formés respectivement entre la base 133A de ladite première pyramide, et une face latérale de la même première pyramide. Ici, tous les angles à la base de la première pyramide prennent la même valeur $\varphi$, puisque la première pyramide est une pyramide droite.

De même, des angles à la base de la seconde pyramide, sont les angles formés respectivement entre la base 132A de ladite seconde pyramide, et une face latérale de la même première pyramide. Ici, les faces latérales des première et seconde pyramides sont parallèles deux à deux, de sorte que les angles à la base de la première pyramide et les angles à la base de la seconde pyramide sont égaux deux à deux. Les angles à la base de la seconde pyramide prennent donc chacun cette même valeur $\varphi$.

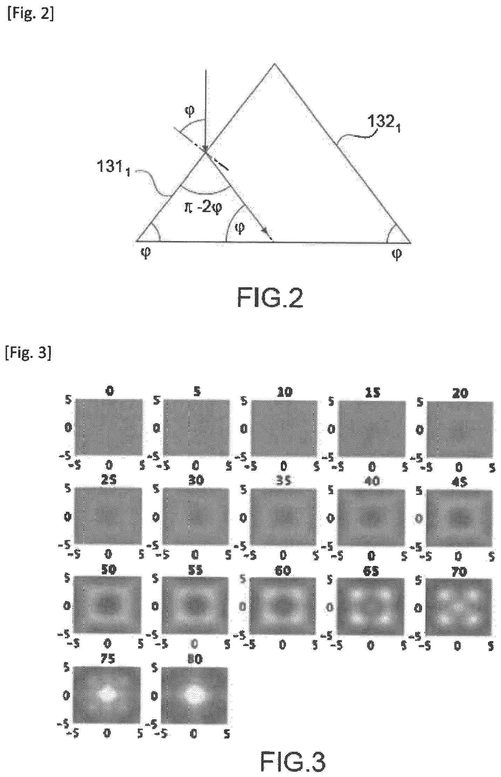

La valeur $\varphi$ est telle qu'un rayonnement lumineux, arrivant à incidence normale sur la matrice de pixel du côté opposé aux photodiodes, traverse la structure réfractive 131 sans être réfléchi à l'intérieur de cette dernière. On parle de régime nominal, par opposition à un régime de résonance dans lequel ledit rayonnement lumineux est réfléchi une ou plusieurs fois à l'intérieur de la structure réfractive. Le régime nominal est obtenu pour des valeurs $\varphi$ strictement inférieures à une valeur limite supérieure $\varphi_{max}$. La valeur limite supérieure $\varphi_{max}$ est la valeur de $\varphi$ pour laquelle ledit rayonnement lumineux, arrivant sur la structure réfractive au niveau d'une première face latérale $131_1$, est réfracté dans la structure réfractive parallèle à une seconde face latérale $132_1$. La première face latérale $131_1$ appartient à la première pyramide tronquée. La seconde face latérale $132_1$ appartient à l'évidement 132. Cette situation est illustrée à la figure 2, qui représente une partie de la structure réfractive 131 selon une vue en coupe dans un plan parallèle au plan (xOz). On voit à la figure 2 que cette situation correspond au cas où l'on a :

[Math 5]

$$\pi - 2\varphi_{max} + \theta = \frac{\pi}{2} \qquad (2)$$

avec $\theta$ l'angle de réfraction dudit rayonnement lumineux dans la structure réfractive 131.

D'après les lois de Snell-Descartes, on a :
[Math 6]

$$n_0 \sin(\theta) = n_1 \sin(\varphi_{max}) \qquad (3)$$

avec $n_0$ l'indice optique d'un milieu environnant entourant les structures réfractives du côté opposé à l'étage 110 comportant les photodiodes, et $n_1$ un indice optique desdites structures réfractives.

Par conséquent, l'équation (2) se traduit par :
[Math 7]

$$2\varphi_{max} - \sin^{-1}\left(\frac{n_0}{n_1}\sin(\varphi_{max})\right) = \frac{\pi}{2} \qquad (4)$$

Ainsi, pour avoir un fonctionnement en régime nominal, la valeur $\varphi$ vérifie :
[Math 8]

$$2\varphi - \theta = 2\varphi - \sin^{-1}\left(\frac{n_0}{n_1}\sin(\varphi)\right) < \frac{\pi}{2} \qquad (5)$$

$n_0$ est de préférence l'indice optique de l'air, environ égal à l'unité.

$n_1$ est avantageusement compris entre 1,2 et 3,5, de préférence entre 1,3 et 1,7, par exemple égal à 1,4 ou 1,6. Pour cela, les structures réfractives sont par exemple en résine, en polydiméthylsiloxane (PDMS), en sulfure de zinc (ZnS), en dioxyde de silicium, en silicium, en nitrure de silicium, ou un autre matériau transparent aux longueurs d'onde à détecter (de préférence un diélectrique).

Dans le régime nominal, les rayons arrivant à incidence sensiblement normale sur la matrice de pixels se concentrent, après traversée de la structure réfractive, dans une zone d'interférence 140 située dans l'étage 110 comportant des photodiodes.

La zone d'interférence 140 s'étend dans un volume entourant latéralement une région centrale du pixel, au regard d'une ligne d'intersection 135 entre la première pyramide et la seconde pyramide associées à ladite structure réfractive. La ligne d'intersection 135 s'étend du côté de la structure réfractive opposé à l'étage 110 comportant les photodiodes. Dans le mode de réalisation des figures 1A et 1B, les faces latérales de la première pyramide tronquée et les faces latérales de l'évidement se rejoignent deux à deux au niveau de cette ligne d'intersection 135. Dans des modes de réalisation décrits plus loin, la ligne d'intersection 135 est une ligne virtuelle située à distance de la structure réfractive 131, les faces latérales de la première pyramide tronquée et de l'évidement n'étant pas en contact du côté opposé aux photodiodes. En tout état de cause, la ligne d'intersection 135 suit de préférence un chemin centré sur le pixel de forme homothétique des pourtours du pixel (ici de forme carré ou rectangulaire).

L'énergie lumineuse des rayons arrivant sur le pixel 100 est concentrée dans la zone d'interférence 140, avec un maximum d'amplitude situé exactement au regard de la ligne d'intersection 135. On peut montrer qu'en régime nominal, ce maximum est toujours présent. Cette particularité est perdue en régime de résonance. Dans certains cas, il peut y avoir des maxima d'ordre deux de part et d'autre du maximum.

Dans chaque pixel 100, la zone d'interférence 140 s'étend dans le volume 111, sans dépasser dans la région centrale 112 dudit pixel. Les rayons lumineux arrivant à incidence sensiblement normale sur le pixel se concentrent donc dans la zone d'absorption dudit pixel, où ils peuvent former des porteurs de charge aptes à générer un courant dans la photodiode. En particulier, même lorsque ces rayons arrivent sur le pixel au regard de sa région centrale 112, ils sont déviés vers la périphérie du pixel et parviennent jusqu'à la zone d'absorption. On réalise ainsi un dispositif de photo-détection avec un rendement de capture, et donc une sensibilité augmentés.

Dans une variante avantageuse, les pixels de la matrice de pixels sont répartis selon un maillage carré, et avec un pas de répartition P. Le maximum d'amplitude de l'énergie dans la zone d'interférence 140 s'étend alors selon un chemin carré de côté P/2, centré sur le pixel. Dans une vue en coupe dans un plan parallèle au plan (Oxz), les maxima se trouvent alors aux abscisses *P/4* et *3P/4,* le long de l'axe (Ox).

De manière avantageuse, la hauteur h des structures réfractives 131 est suffisante pour leur permettre d'être « vues » par le rayonnement lumineux à détecter. Pour cela, la hauteur h vérifie :

[Math 9]

$$h \geq \frac{\lambda_{moy}}{2n_1} \tag{6}$$

avec $n_1$ l'indice optique des structures réfractives et $\lambda_{moy}$ la longueur d'onde centrale d'une plage de longueurs d'onde que les photodiodes sont aptes à détecter.

La hauteur h est définie selon l'axe (Oz) orthogonal au plan de la matrice de pixels. Pour des structures réfractives d'indice $n_1$=1.4, cette hauteur est supérieure à 4 $\mu$m, voire supérieure à 5 $\mu$m.

Dans le mode de réalisation illustré aux figures 1A et 1B, et lorsque les pixels sont répartis selon un maillage carré avec un pas de répartition P, l'équation (6) se traduit par une condition sur la valeur $\varphi$ de l'angle à la base de la première pyramide. Cette valeur $\varphi$ doit être strictement supérieure à une valeur limite inférieure $\varphi_{min}$ qui vérifie :

[Math 10]

$$\varphi_{min} = \arctan\left(\frac{2\lambda_{moy}}{n_1 P}\right) \tag{7}$$

La valeur $\varphi$ doit alors être comprise entre la valeur limite inférieure $\varphi_{min}$ définie à l'équation (7), et la valeur limite supérieure $\varphi_{max}$ définie à l'équation (4). En pratique, et pour un indice optique des structures réfractives proche de 1,4, la valeur $\varphi$ est avantageusement comprise entre 50° et 65°, voire entre 50° et 60°.

A la figure 3, on a illustré la répartition du champ électromagnétique sous la structure réfractive du dispositif de photo-détection des figures 1A et 1B, pour différentes valeurs de la valeur $\varphi$ de l'angle à la base de la première pyramide, et pour un indice optique des structures réfractives proche de 1,4. Les pixels de la matrice de pixels sont répartis ici selon un maillage carré, avec un pas de répartition *P=10$\mu$m.* Sur chaque figure de répartition, l'axe des abscisses est une distance selon l'axe (Ox), en $\mu$m, l'axe des ordonnée est une distance selon l'axe (Oy), en $\mu$m. La valeur $\varphi$ exprimée en degrés est noté au-dessus de chaque figure de répartition. Le champ électromagnétique provient d'un rayonnement lumineux arrivant à incidence sensiblement normale sur la matrice de pixels, du côté opposé aux photodiodes. Les teintes plus claires correspondent à une plus forte intensité du champ électromagnétique.

On voit que pour $\varphi$ compris entre 50° et 65° et pour un indice optique des structures réfractives proche de 1,4, on concentre la majeure partie du champ électromagnétique dans une région ouverte au centre, centrée sur le pixel. En dessous de 50°, la répartition du champ dans le pixel reste relativement homogène. Au-dessus de 65°, un maximum d'intensité apparaît au centre du pixel, ce qui est contraire à l'effet recherché (régime de résonance).

On peut montrer également que des structures réfractives bas indice, c'est-à-dire d'indice optique $n_1$ proche de 1,4, sont particulièrement avantageuses. Par « proche de 1,4 », on entend compris entre 1,2 et 1,7 et de préférence entre 1,35 et 1,45. Ces faibles valeurs d'indice permettent que la transmission optique à l'interface entre l'airenvironnant et les structures réfractives soit proche de l'unité, pour des angles à la base $\varphi$ compris entre 50° et 65° (les rayons lumineux arrivant à incidence normale sur la matrice de pixel se retrouvent alors orientés sensiblement à l'angle de Brewster relativement aux faces latérales de la structure réfractive). Le cas échéant, lorsque leur indice optique est supérieur à 1,4, les structures réfractives peuvent être recouvertes d'une couche antireflet conforme, du côté opposé aux photodiodes. En tout état de cause, des valeurs d'indice optique $n_1$ trop élevées peuvent empêcher qu'il existe une valeur de $\varphi$ comprise entre la valeur limite inférieure $\varphi_{min}$ et la valeur limite supérieure $\varphi_{max}$.

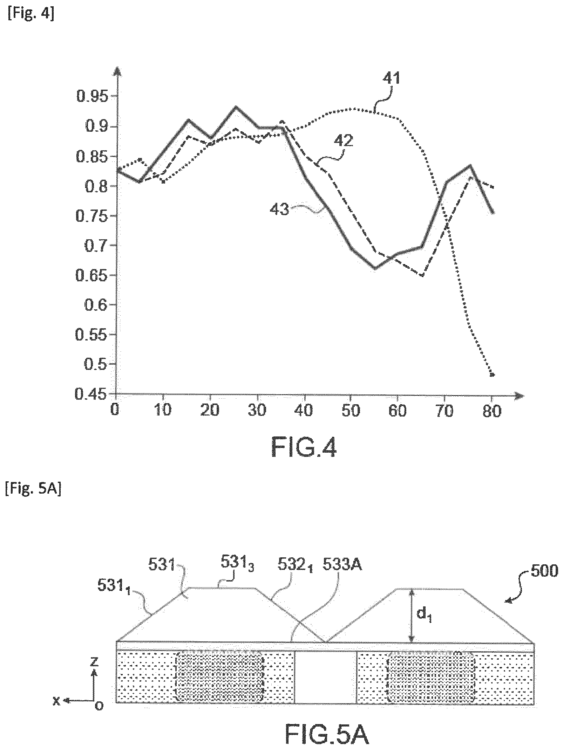

A la figure 4, on a illustré des courbes de l'absorption par un pixel du dispositif de photo-détection des figures 1A et 1B, en fonction de la valeur $\varphi$ prise par l'angle à la base de la première pyramide, et pour différentes valeurs de l'indice optique de la structure réfractive. Les pixels de la matrice de pixels sont répartis ici selon un maillage carré, et avec un pas de répartition *P=10$\mu$m.* La région centrale comporte une ouverture traversante, ou via, de 4 $\mu$m de diamètre.

L'axe des abscisses est la valeur de l'angle $\varphi$, en degrés. L'axe des ordonnées est un taux d'absorption. Les courbes 41, 42, 43 correspondent respectivement à une valeur $\eta_1$=1.4, $n_1$=2.7, $n_1$=3.4 de l'indice optique de la structure réfractive.

Le taux d'absorption à $\varphi$=0° correspond au taux d'absorption en l'absence de structure réfractive. Ce taux vaut ici 0,82. On observe que c'est l'indice $n_1$=1,4 qui offre les valeurs les plus élevées du taux d'absorption, ainsi que la plus large plage de fonctionnement (plage de valeurs de $\varphi$ offrant un taux d'absorption supérieur à un seuil prédéterminé).

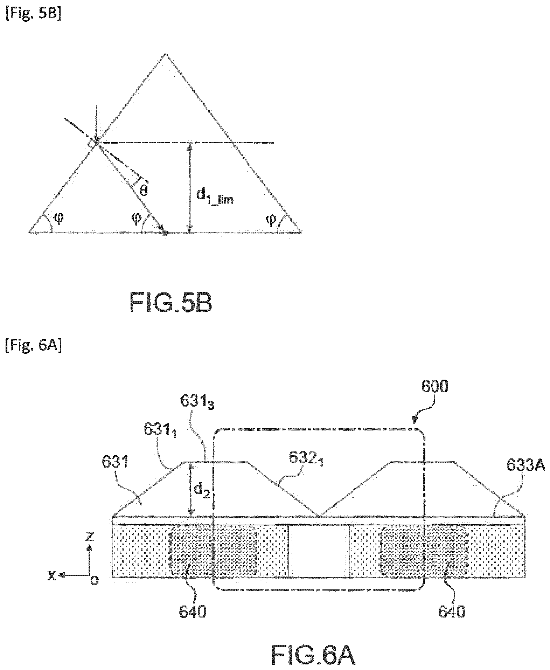

Les figures 5A et 5B illustrent un deuxième mode de réalisation d'un dispositif de photo-détection selon l'invention, qui ne sera décrit que pour ses différences relativement au mode de réalisation des figures 1A et 1B.

Comme détaillé ci-dessus, la structure réfractive réalise une concentration d'énergie dans l'étage comportant les photodiodes, avec un maximum d'énergie situé sensiblement au regard de la ligne d'intersection entre la première pyramide et la seconde pyramide associées à ladite structure réfractive. Le deuxième mode de réalisation est basé sur l'idée que tous les rayons lumineux arrivant sur le pixel ne contribuent pas à ce maximum d'énergie. En particulier, il est possible d'écrêter la structure réfractive, tout en conservant une même répartition d'énergie dans l'étage comportant les photodiodes. On peut en particulier tronquer la structure réfractive jusqu'au niveau d'un premier plan limite situé à une distance $d_{1\_lim}$ de la face inférieure de la structure réfractive, tout en conservant une même répartition d'énergie dans l'étage comportant les photodiodes. Le premier plan limite s'étend parallèle au plan (Oxy) de la matrice de pixels. La face inférieure de la structure réfractive est formée par la base de la première pyramide associée à ladite structure réfractive. La distance $d_{1\_lim}$ est mesurée selon un axe (Oz) orthogonal au plan de la matrice de pixels. On peut montrer que $d_{1\_lim}$ vérifie :
[Math 11]

$$d_{1\_lim} = \frac{P}{4} \frac{\tan(\varphi)}{(1 + \tan(\varphi)\tan(\varphi - \theta))} \qquad (8)$$

avec P le pas de répartition des pixels de la matrice de pixels ;
$\varphi$ la valeur de l'angle à la base de la première pyramide ; et
$\theta$ l'angle de réfraction, dans la structure réfractive, d'un rayonnement lumineux arrivant à incidence normale sur la matrice de pixels. L'angle $\theta$ vérifie la condition de l'équation (3).

Lorsque les pixels sont répartis selon un maillage rectangulaire, P est le plus petit des deux pas de répartition et $\varphi$ est l'angle à la base selon l'axe de ce plus petit pas.

La figure 5B représente une partie de la structure réfractive, selon une vue en coupe dans un plan parallèle au plan (xOz). La figure 5B illustre en particulier la distance $d_{1\_lim}$, ainsi que les droites de construction permettant d'arriver à l'équation (8).

La figure 5A illustre un pixel 500 d'un dispositif de photo-détection selon le deuxième mode de réalisation, dans une vue en coupe dans un plan parallèle au plan (Oxz). Dans chaque pixel 500, les faces latérales $531_1$ de la première pyramide tronquée et les faces latérales $532_1$ de l'évidement en forme de seconde pyramide renversées ne sont pas en contact deux à deux, du côté opposé aux photodiodes. Elles sont séparées par une surface supérieure $531_3$ de la structure réfractive 531. Ladite surface supérieure $531_3$ s'étend du côté de la structure réfractive opposé aux photodiodes, avec une forme ouverte au centre. Ici, ladite surface supérieure $531_3$ est une surface plane, située à la distance $d_1$ de la face inférieure 533A de la structure réfractive, avec $d_1$ strictement supérieur à $d_{1\_lim}$, et sensiblement égal à $d_{1\_lim}$, à plus ou moins 20% près, voire à plus ou moins 10% près.

Dans une variante non représentée, la surface supérieure $531_3$ est une surface non plane. Dans ce cas, chaque point de coordonnées (x, y), appartenant à ladite surface supérieure $531_3$ est situé à une distance $d_1(x, y)$ de la face inférieure 533A de la structure réfractive. La distance $d_1(x, y)$ vérifie :
[Math 12]

$$d_1(x, y) \geq d_{1\_lim}, \forall x, \forall y \qquad (9)$$

De préférence, $d_1(x, y)$ est en outre sensiblement égal à $d_{1\_lim}$ pour tout x et pour tout y, à plus ou moins 20% près, voire à plus ou moins 10% près.

Une même matrice de pixels peut comprendre des structures réfractives entières, comme aux figures 1A et 1B, et des structures réfractives tronquées, comme à la figure 5A, avec différents plans de troncature d'un pixel à l'autre. Tant que l'équation (9) est vérifiée sur chacun des pixels, cela n'entraîne pas de différence de rendement notable d'un pixel à l'autre de la matrice de pixels. Cette particularité offre une grande souplesse à la fabrication. On peut notamment tolérer des différences entre les pixels, liées à des portions plus ou moins grandes de matériau restant au fond d'un moule d'impression lors d'une étape de fabrication des structures réfractives.

Les figures 6A et 6B illustrent un troisième mode de réalisation d'un dispositif de photo-détection selon l'invention, qui ne sera décrit que pour ses différences relativement au mode de réalisation des figures 1A et 1B.

La figure 6A illustre un pixel 600 d'un dispositif de photo-détection selon ce troisième mode de réalisation, dans une vue en coupe dans un plan parallèle au plan (Oxz). Le pixel 600 est encadré par des traits mixtes. On a également représenté en figure 6A des portions de pixels adjacents. Selon ce mode de réalisation, chaque structure réfractive 631 s'étend sur plusieurs pixels, et les zones d'interférence 640 correspondantes s'étendent à cheval sur des pixels adjacents. L'élément de focalisation de chaque pixel est constitué alors par une portion seulement d'au moins une structure réfractive.

Dans chaque structure réfractive, les faces latérales $631_1$ de la première pyramide tronquée et les faces latérales $632_1$ de l'évidement ne sont pas en contact deux à deux du côté opposé aux photodiodes. Elles sont séparées par une surface supérieure $631_3$ de la structure réfractive 631. Les plans des faces latérales $631_1$ de la première pyramide tronquée et des faces latérales $632_1$ de l'évidement se rejoignent, du côté opposé aux photodiodes, selon une ligne d'intersection située au regard de frontières entre des pixels adjacents.

Pour les mêmes raisons que détaillées ci-dessus, il est possible d'écrêter la structure réfractive tout en conservant les mêmes caractéristiques de répartition d'énergie dans l'étage comportant les photodiodes. En particulier, on peut tronquer la structure réfractive jusqu'au niveau d'un deuxième plan limite situé à une distance $d_{2\_lim}$ de la face inférieure de la structure réfractive, tout en conservant une même répartition d'énergie dans l'étage comportant les photodiodes. Le deuxième plan limite s'étend parallèle au plan (Oxy) de la matrice de pixels. La distance $d_{2\_lim}$ est mesurée selon un axe (Oz) orthogonal au plan de la matrice de pixels. On peut montrer que $d_{2\_lim}$ vérifie :
[Math 13]

$$d_{2\_lim} = \frac{P}{2} \frac{\tan(\varphi)}{(1 + \tan(\varphi)\tan(\varphi - \theta))} \qquad (10)$$

avec P le pas de répartition des pixels de la matrice de pixels ;

$\varphi$ la valeur de l'angle à la base de la première pyramide ; et

$\theta$ l'angle de réfraction, dans la structure réfractive, d'un rayonnement lumineux arrivant à incidence normale sur la matrice de pixels ($\theta$ vérifie la condition de l'équation (3)).

Lorsque les pixels sont répartis selon un maillage rectangulaire, P est le plus petit des deux pas de répartition et $\varphi$ est l'angle à la base selon l'axe de ce plus petit pas.

Selon le troisième mode de réalisation, on écrête la structure réfractive légèrement en-dessous du deuxième plan limite, de manière à espacer les maxima d'énergie relativement aux frontières entre deux pixels voisins. On limite ainsi la diaphonie entre des pixels adjacents.

A la figure 6A, la surface réfractive est écrêtée selon une face plane $631_3$, située à une distance $d_2$ de la face inférieure 633A de la structure réfractive, avec $d_2$ strictement inférieure à $d_{2\_lim}$. La différence entre $d_2$ et $d_{2\_lim}$ est par exemple comprise entre 0,8 $\mu$m et 1,2 $\mu$m, par exemple égale à 1 $\mu$m.

La figure 6B représente une partie de la structure réfractive 631, selon une vue en coupe dans un plan parallèle au plan (xOz). A la figure 6B, on a représenté la distance $d_{2\_lim}$. La différence $\Delta d$ entre $d_2$ et $d_{2\_lim}$ est adaptée pour éviter qu'un photon arrivant au regard d'un pixel prédéterminé, émerge de la structure réfractive suffisamment proche d'un pixel voisin pour diffuser jusque dans la région d'absorption dudit pixel voisin. De préférence, $\Delta d$ est adaptée pour que ce photon émerge de la structure réfractive à une distance D du pixel le plus proche, avec $D \approx \lambda_{moy}/n_{abs}$, avec $n_{abs}$ l'indice optique de la région d'absorption et $\lambda_{moy}$ la longueur d'onde centrale d'une plage de longueurs d'onde que les photodiodes sont aptes à détecter.

Selon une variante non représentée, la surface supérieure $631_3$ est une surface non plane. Dans ce cas, chaque point de coordonnées (x, y) appartenant à ladite surface supérieure $631_3$ est situé à une distance $d_2(x, y)$ de la face inférieure 633A de la structure réfractive. La distance $d_2(x, y)$ vérifie :
[Math 14]

$$d_2(x, y) < d_{2\_lim}, \forall x, \forall y \qquad (11)$$

De préférence, $d_2(x, y)$ est en outre sensiblement égal à $\{d_{2\_lim} - 1\ \mu m\}$ pour tout x et pour tout y, à plus ou moins 10% près, voire à plus ou moins 5% près.

Ce mode de réalisation est particulièrement avantageux lorsque les photodiodes sont réparties selon un faible pas de pixel, par exemple inférieur ou égal à 7,5 $\mu$m. Il est d'autant plus avantageux en combinaison avec des photodiodes munies chacune d'un via central, de diamètre supérieur ou égal à la moitié du pas de pixel. On a par exemple un pas de 7,5 $\mu$m et des vias en forme de cylindre de révolution de diamètre 5 $\mu$m.

La figure 7 illustre de façon schématique un pixel 700 d'un quatrième mode de réalisation d'un dispositif de photo-détection selon l'invention, qui ne sera décrit que pour ses différences relativement au mode de réalisation des figures 1A et 1B. Dans ce mode de réalisation, la forme de la structure réfractive 731 est définie par une première pyramide tronquée, munie d'un évidement 732 en forme de seconde pyramide tronquée. Le fond de l'évidement 132 est plan, du côté de l'étage comportant les photodiodes. Une coupe de la structure réfractive 731, dans un plan parallèle au plan (Oxz), présente alors la forme de deux triangles séparés par un espace libre entre eux deux.

Les figures 8A et 8B illustrent, selon des vues en coupe, des vues détaillées de deux variantes du premier mode de réalisation d'un dispositif de photo-détection selon l'invention.

A la figure 8A, les photodiodes 815A comportent chacune une ouverture traversante 816A, ou via, centrée sur le pixel correspondant. Le via 816A est entouré ici d'une région 817A fortement dopée N, elle-même entourée d'une région 818A faiblement dopée N (optionnelle), elle-même entourée d'une région 819A dopée P. La région d'absorption s'étend dans la région 819A dopée P. La région d'absorption s'étend ici, en totalité, dans un volume entourant latéralement une région centrale du pixel. Le diamètre du via 816A est par exemple de 5 $\mu$m, pour un pas de pixel de 15 $\mu$m. Il est difficile de réaliser des vias de diamètre inférieur à 4 $\mu$m, de sorte que le via occupe un volume très important dans le pixel pour des pas de pixel inférieurs ou égaux à 10 $\mu$m.

Selon ce mode de réalisation, la face qui reçoit les structures réfractives 811A est la face avant de la matrice de photodiodes, du côté opposé à un substrat sur lequel reposent les photodiodes. Un procédé de fabrication des structures réfractives comprend alors les étapes suivantes :

- planarisation de la matrice de photodiodes, pour recouvrir les photodiodes et leurs vias d'une fine couche plane ;
- dépôt, sur ladite fine couche plane, d'une couche épaisse d'un matériau souple tel qu'une résine, du polydiméthylsiloxane (PDMS), du dioxyde de silicium, etc;
- impression de ladite couche épaisse, à l'aide d'un moule pressé contre la couche épaisse. La couche épaisse est nommée couche d'impression. Le moule est de préférence un moule en silicium. Sa forme est complémentaire de la forme souhaitée pour les structures réfractives.

A la figure 8B, les photodiodes 815B comportent chacune un caisson 816B dopé P, centré sur le pixel, entouré d'une région d'absorption 817B dopée N, entourée elle-même d'une région de séparation 818B fortement dopée N. Les photodiodes 815B s'étendent au-dessus d'un substrat 819B et d'une couche de confinement 814B. On a également représenté un connecteur 813B s'enfonçant dans le caisson 816B dopé P. La région d'absorption s'étend ici en majeure partie dans un volume entourant latéralement une région centrale du pixel, entourant ici le caisson 816B dopé P. Une fine couche de matériau, sous le caisson 816B dopé P, appartient cependant également à ladite région d'absorption.

Selon ce mode de réalisation, la face qui reçoit les structures réfractives 811B est la face arrière de la matrice de photodiodes, du côté du substrat 819B. Les structures réfractives peuvent donc être formées directement dans ce substrat, par exemple par nano-usinage direct par faisceau d'électrons focalisé. De préférence, le substrat est aminci avant la réalisation des structures réfractives. En variante, le substrat est retiré (par exemple chimiquement), puis on dépose une couche d'impression qui est ensuite structurée par nano-usinage direct par faisceau d'électrons focalisé, ou par impression comme décrit ci-dessus.

Il est connu qu'une couche de silicium peut être gravée par gravure humide à travers un masque de gravure 91, par exemple à l'aide d'une solution de KOH (hydroxyde de potassium). La cristallographie du silicium impose alors un angle $\alpha$ d'environ 54° entre une face de la couche de silicium recevant le masque de gravure et une face latérale d'un évidement gravé dans ladite couche. Il est donc particulièrement avantageux de réaliser les structures réfractives selon l'invention par impression à l'aide d'un moule en silicium, la valeur 54° étant située dans un intervalle préféré des angles définissant la forme des structures réfractives selon l'invention, lorsque ces dernières ont leur indice optique proche de 1,4.

La figure 9 illustre de façon schématique un détail d'un moule en silicium 90 pouvant être utilisé pour réaliser les structures réfractives selon l'invention, recouvert de son masque de gravure 91 (le masque de gravure est retiré avant utilisation du moule pour former les structures réfractives). L'homme du métier saura aisément dimensionner le masque 91 et fixer les durées de gravures de manière à obtenir la forme souhaitée des structures réfractives.

L'invention n'est pas limitée aux exemples décrits ci-avant, et de nombreuses variantes peuvent être mises en œuvre sans sortir du cadre de l'invention, par exemple en combinant les différents modes de réalisation, ou avec des structures réfractives dont la forme est définie par des pyramides non droites, ou avec des structures réfractives dont la forme est définie par des pyramides dont la base a une forme polygone quelconque, ou avec des structures réfractives dont la forme est définie par des pyramides dont les faces latérales ne sont pas deux à deux parallèles, ou avec des structures réfractives dont la forme est définie par des pyramides dont les angles à la base prennent différentes valeurs distinctes.

L'invention couvre de préférence un dispositif de photo-détection adapté à la détection dans l'infrarouge. L'invention n'est cependant pas limitée à cette gamme de longueurs d'onde, et peut notamment couvrir des dispositifs de photo-détection dans le visible. De préférence, le pas de pixel est sensiblement égal à la longueur d'onde à détecter.

L'invention est particulièrement avantageuse lorsque dans chaque pixel, la région centrale reçoit un via de diamètre supérieur ou égal à la moitié du pas de pixel.

L'invention est également particulièrement avantageuse lorsque la forme des structures réfractives est définie par une première pyramide d'angle à la base compris entre 53° et 56°. Ces valeurs permettent une fabrication aisée par impression à l'aide d'un moule en silicium.

**Revendications**

1. Dispositif de photo-détection comportant une matrice de pixels, dans lequel les pixels (100 ; 500 ; 600 ; 700) comprennent chacun une photodiode (815A ; 815B) dont la région d'absorption s'étend en totalité ou en majeure partie dans un volume (111) entourant une région centrale (112) du pixel,

   - chaque pixel comporte en outre un élément de focalisation, pour focaliser sur la région d'absorption (819A ; 817B) correspondante un rayonnement lumineux arrivant à incidence sensiblement normale sur ledit pixel ;
   - les éléments de focalisation sont constitués d'un ensemble de structures réfractives (131 ; 531 ; 631 ; 731), **caractérisé en ce que**: chaque structure réfractive étant formée par une première pyramide (133) tronquée et munie d'un évidement (132), ladite première pyramide ayant sa base (133A) qui est parallèle au plan de la matrice de pixels et située du côté des photodiodes, et l'évidement (132) ayant la forme d'une seconde pyramide (134) entière ou tronquée dont la base (132A) s'étend parallèle au plan de la matrice de pixels du côté de la structure réfractive opposé aux photodiode, ; et
   - les angles à la base $\varphi_i$ des premières pyramides et des secondes pyramides vérifient chacun :

   [Math 15]

   $$2 * \varphi_i - \sin^{-1}\left(\frac{n_0}{n_1}\sin(\varphi_i)\right) < \frac{\pi}{2}$$

   avec $n_0$ l'indice optique d'un milieu environnant entourant les structures réfractives (131 ; 531 ; 631 ; 731) du côté opposé aux photodiodes, et $n_1$ un indice optique desdites structures réfractives.

2. Dispositif selon la revendication 1, **caractérisé en ce qu'**une hauteur h de chacune desdites structures réfractives (131 ; 531 ; 631 ; 731) vérifie :

   [Math 16]

   $$h \geq \frac{\lambda_{moy}}{2n_1}$$

   avec $n_1$ l'indice optique desdites structures réfractives (131 ; 531 ; 631 ; 731) et $\lambda_{moy}$ la longueur d'onde centrale d'une plage spectrale de détection du dispositif de photo-détection.

3. Dispositif selon la revendication 1 ou 2, **caractérisé en ce que** les angles à la base de chacune desdites premières pyramides et secondes pyramides sont compris chacun entre 50° et 60°.

4. Dispositif selon l'une quelconque des revendications 1 à 3, **caractérisé en ce que** l'indice optique desdites structures réfractives (131 ; 531 ; 631 ; 731) est inférieur ou égal à 1,7.

5. Dispositif selon l'une quelconque des revendications 1 à 4, **caractérisé en ce que** dans chaque structure réfractive (131 ; 531 ; 631 ; 731), les faces latérales ($132_1$ ; $532_1$; $632_1$) de la seconde pyramide sont parallèles deux à deux aux faces latérales ($131_1$ ; $531_1$; $631_1$) de la première pyramide.

6. Dispositif selon l'une quelconque des revendications 1 à 5, **caractérisé en ce que** dans chaque structure réfractive (131 ; 531 ; 631 ; 731), la première pyramide est tronquée selon un plan parallèle au plan de la matrice de pixels.

7. Dispositif selon l'une quelconque des revendications 1 à 6, **caractérisé en ce que** dans chaque structure réfractive (131 ; 531 ; 631 ; 731), l'évidement (132) a la forme d'une seconde pyramide entière qui s'étend jusqu'à la base (133A) de la première pyramide tronquée.

8. Dispositif selon l'une quelconque des revendications 1 à 7, **caractérisé en ce que** dans chaque structure réfractive (131 ; 731), les faces latérales ($131_1$) de la première pyramide tronquée et les faces latérales ($132_1$) de l'évidement se rejoignent deux à deux du côté opposé aux photodiodes.

**9.** Dispositif selon l'une quelconque des revendications 1 à 7, **caractérisé en ce que** dans l'une au moins des structures réfractives (531 ; 631), les faces latérales (531$_1$ ; 631$_1$) de la première pyramide tronquée et les faces latérales (532$_1$; 632$_1$) de l'évidement sont séparées deux à deux par une surface supérieure (531$_3$ ; 631$_3$) de la structure réfractive, du côté opposé aux photodiodes.

**10.** Dispositif selon l'une quelconque des revendications 1 à 9, **caractérisé en ce que** chaque structure réfractive (131 ; 531 ; 731) s'étend sur un unique pixel.

**11.** Dispositif selon la revendication 10, **caractérisé en ce que** dans l'une au moins des structures réfractives (531), les faces latérales (531$_1$) de la première pyramide tronquée et les faces latérales (532$_1$) de l'évidement sont séparées deux à deux par une surface supérieure (531$_3$) de la structure réfractive située du côté opposé aux photodiodes, et **en ce que** chaque point de ladite surface supérieure (531$_3$) est espacé de la face inférieure (533A) de la structure réfractive, d'une distance $d_1(x, y)$ supérieure ou égale à $d_{1\_lim}$ et également sensiblement égale à $d_{1\_lim}$ à plus ou moins 10% près, avec :

[Math 17]

$$d_{1\_lim} = \frac{P}{4} * \frac{\tan(\varphi_j)}{1 + \tan(\varphi_j) * \tan(\varphi_j - \theta)}$$

avec P un pas de pixel de la matrice de pixels ;
$\varphi_j$ un angle à la base de ladite première pyramide ; et
$\theta$ l'angle de réfraction, dans la structure réfractive (531) d'un rayonnement lumineux arrivant à incidence normale sur la matrice de pixels.

**12.** Dispositif selon l'une quelconque des revendications 1 à 9, **caractérisé en ce que** chaque structure réfractive (631) s'étend à cheval sur plusieurs pixels voisins (600).

**13.** Dispositif selon la revendication 12, **caractérisé en ce que** dans l'une au moins des structures réfractives (631), les faces latérales (631$_1$) de la première pyramide tronquée et les faces latérales (632$_1$) de l'évidement sont séparées deux à deux par une surface supérieure (631$_3$) de la structure réfractive située du côté opposé aux photodiodes, et **en ce que** chaque point de ladite surface supérieure (631$_3$) est espacé de la face inférieure (633A) de la structure réfractive, d'une distance $d_2(x, y)$ strictement inférieure à :

[Math 18]

$$\frac{P}{2} * \frac{\tan(\varphi_j)}{1 + \tan(\varphi_j) * \tan(\varphi_j - \theta)}$$

avec P un pas de pixel de la matrice de pixels ;
$\varphi_j$ un angle à la base de ladite première pyramide ; et
$\theta$ l'angle de réfraction, dans la structure réfractive (631), d'un rayonnement lumineux arrivant à incidence normale sur la matrice de pixels.

**14.** Dispositif selon l'une quelconque des revendications 1 à 13, **caractérisé en ce qu'**il comporte une couche antireflet (120) entre les structures réfractives (131 ; 531 ; 631 ; 731) et les photodiodes.

**15.** Procédé de réalisation d'un dispositif selon l'une quelconque des revendications 1 à 14, dans lequel les angles ($\varphi$) à la base des premières pyramides et des secondes pyramides sont compris chacun entre 50° et 60°, le procédé étant **caractérisé en ce qu'**il comporte les étapes suivantes :

- dépôt d'une couche d'impression de manière à recouvrir une matrice de photodiodes, lesdites photodiodes ayant chacune leur région d'absorption qui s'étend en totalité ou en majeure partie dans un volume (11) entourant une région centrale (112) du pixel ; et
- impression de la couche d'impression pour former les structures réfractives (131 ; 531 ; 631 ; 731), en utilisant un moule en silicium (90) que l'on presse contre la couche d'impression.

**Patentansprüche**

1. Photodetektionsvorrichtung mit einer Matrix von Pixeln, wobei die Pixel (100; 500; 600; 700) jeweils eine Photodiode (815A; 815B) enthalten, deren Absorptionsbereich sich vollständig oder größtenteils in einem Volumen (111) erstreckt, das einen zentralen Bereich (112) des Pixels umgibt, wobei

   - jedes Pixel ferner ein Fokussierungselement enthält, um eine im Wesentlichen normal auf das Pixel einfallende Lichtstrahlung auf den entsprechenden Absorptionsbereich (819A; 817B) zu fokussieren;
   - die Fokussierungselemente aus einer Anordnung von brechenden Strukturen (131; 531; 631; 731) bestehen, **dadurch gekennzeichnet, dass**
   jede brechende Struktur aus einer ersten abgestumpften Pyramide (133) gebildet ist, die mit einer Ausnehmung (132) versehen ist, wobei die erste Pyramide mit ihrer Grundfläche (133A) parallel zur Ebene der Pixelmatrix verläuft und auf der Seite der Photodioden angeordnet ist, und die Ausnehmung (132) die Form einer vollständigen oder abgestumpften zweiten Pyramide (134) hat, deren Grundfläche (132A) parallel zur Ebene der Pixelmatrix auf der den Photodioden gegenüberliegenden Seite der brechenden Struktur verläuft; und
   - die Winkel an der Grundfläche $\varphi_i$ der ersten Pyramiden und der zweiten Pyramiden jeweils erfüllen:

   [Math 15]

   $$2 * \varphi_i - \sin^{-1}\left(\frac{n_0}{n_1}\sin(\varphi i)\right) < \frac{\pi}{2}$$

   worin $n_0$ der optische Index eines umgebenden Mediums ist, das die brechenden Strukturen (131; 531; 631; 731) auf der den Photodioden gegenüberliegenden Seite umgibt, und $n_1$ ein optischer Index der genannten brechenden Strukturen ist.

2. Vorrichtung nach Anspruch 1, **dadurch gekennzeichnet, dass** eine Höhe $h$ jeder der brechenden Strukturen (131; 531; 631; 731) erfüllt:

   [Math 16]

   $$h \geq \frac{\lambda_{moy}}{2n_1}$$

   worin $n_1$ der optische Index der brechenden Strukturen (131; 531; 631; 731) ist und $\lambda_{moy}$ die zentrale Wellenlänge eines Detektionsspektralbereichs der Photodetektionsvorrichtung ist.

3. Vorrichtung nach Anspruch 1 oder 2, **dadurch gekennzeichnet, dass** die Winkel an der Grundfläche jeder der ersten Pyramiden und der zweiten Pyramiden jeweils zwischen 50° und 60° liegen.

4. Vorrichtung nach einem der Ansprüche 1 bis 3, **dadurch gekennzeichnet, dass** der optische Index der brechenden Strukturen (131; 531; 631; 731) kleiner oder gleich 1,7 ist.

5. Vorrichtung nach einem der Ansprüche 1 bis 4, **dadurch gekennzeichnet, dass** bei jeder brechenden Struktur (131; 531; 631; 731) die Seitenflächen ($132_1$; $532_1$; $632_1$) der zweiten Pyramide paarweise parallel zu den Seitenflächen ($131_1$; $531_1$; $631_1$) der ersten Pyramide verlaufen.

6. Vorrichtung nach einem der Ansprüche 1 bis 5, **dadurch gekennzeichnet, dass** bei jeder brechenden Struktur (131; 531; 631; 731) die erste Pyramide entlang einer Ebene parallel zur Ebene der Pixelmatrix abgestumpft ist.

7. Vorrichtung nach einem der Ansprüche 1 bis 6, **dadurch gekennzeichnet, dass** bei jeder brechenden Struktur (131; 531; 631; 731) die Ausnehmung (132) die Form einer zweiten vollständigen Pyramide hat, die sich bis zur Grundfläche (133A) der ersten abgestumpften Pyramide erstreckt.

8. Vorrichtung nach einem der Ansprüche 1 bis 7, **dadurch gekennzeichnet, dass** bei jeder brechenden Struktur (131; 731) die Seitenflächen ($131_1$) der ersten abgestumpften Pyramide und die Seitenflächen ($132_1$) der Ausnehmung paarweise auf der den Photodioden gegenüberliegenden Seite zusammentreffen.

9. Vorrichtung nach einem der Ansprüche 1 bis 7, **dadurch gekennzeichnet, dass** bei mindestens einer der brechenden Strukturen (531; 631) die Seitenflächen ($531_1$; $631_1$) der ersten abgestumpften Pyramide und die Seitenflächen ($532_1$; $632_1$) der Ausnehmung paarweise durch eine obere Fläche ($531_3$; $631_3$) der brechenden Struktur auf der den Photodioden gegenüberliegenden Seite getrennt sind.

10. Vorrichtung nach einem der Ansprüche 1 bis 9, **dadurch gekennzeichnet, dass** sich jede brechende Struktur (131; 531; 731) über ein einzelnes Pixel erstreckt.

11. Vorrichtung nach Anspruch 10, **dadurch gekennzeichnet, dass** bei zumindest einer der brechenden Strukturen (531) die Seitenflächen ($531_1$) der ersten abgestumpften Pyramide und die Seitenflächen ($532_1$) der Ausnehmung paarweise durch eine obere Fläche ($531_3$) der brechenden Struktur getrennt sind, die sich auf der den Photodioden gegenüberliegenden Seite befindet, und dass jeder Punkt der oberen Fläche ($531_3$) von der unteren Fläche (533A) der brechenden Struktur um einen Abstand $d_1(x, y)$ beabstandet ist, der größer oder gleich $d_{1\_lim}$ ist und auch im Wesentlichen auf plus oder minus 10 % genau gleich $d_{1\_lim}$ ist, wobei:

[Math 17]

$$d_{1\_lim} = \frac{P}{4} * \frac{\tan(\varphi_j)}{1+\tan(\varphi_j)*\tan(\varphi_j - \theta)}$$

worin P ein Pixelabstand der Pixelmatrix ist;
$\varphi_j$ ein Winkel an der Grundfläche der ersten Pyramide ist; und
$\theta$ der Brechungswinkel der normal auf die Pixelmatrix einfallenden Lichtstrahlung in der brechenden Struktur (531) ist.

12. Vorrichtung nach einem der Ansprüche 1 bis 9, **dadurch gekennzeichnet, dass** jede brechende Struktur (631) mehrere benachbarte Pixel (600) überspannt.

13. Vorrichtung nach Anspruch 12, **dadurch gekennzeichnet, dass** bei zumindest einer der brechenden Strukturen (631) die Seitenflächen ($631_1$) der ersten abgestumpften Pyramide und die Seitenflächen ($632_1$) der Ausnehmung paarweise durch eine obere Fläche ($631_3$) der brechenden Struktur getrennt sind, die sich auf der den Photodioden gegenüberliegenden Seite befindet, und dass jeder Punkt der oberen Fläche ($631_3$) von der unteren Fläche (633A) der brechenden Struktur um einen Abstand $d_2(x, y)$ beabstandet ist, der strikt kleiner ist als:

[Math 18]

$$\frac{P}{2} * \frac{\tan(\varphi_j)}{1+\tan(\varphi_j)*\tan(\varphi_j - \theta)}$$

worin P ein Pixelabstand der Pixelmatrix ist;
$\varphi_j$ ein Winkel an der Grundfläche der ersten Pyramide ist; und
$\theta$ der Brechungswinkel einer normal auf die Pixelmatrix einfallenden Lichtstrahlung in der brechenden Struktur (631) ist.

14. Vorrichtung nach einem der Ansprüche 1 bis 13, **dadurch gekennzeichnet, dass** sie eine Antireflexionsschicht (120) zwischen den brechenden Strukturen (131; 531; 631; 731) und den Photodioden aufweist.

15. Verfahren zur Herstellung einer Vorrichtung nach einem der Ansprüche 1 bis 14, wobei die Winkel ($\varphi$) an der Grundfläche der ersten Pyramiden und der zweiten Pyramiden jeweils zwischen 50° und 60° liegen, wobei das Verfahren **dadurch gekennzeichnet ist, dass** es die folgenden Schritte umfasst:

- Abscheiden einer Druckschicht derart, dass sie eine Matrix aus Photodioden bedeckt, wobei die Photodioden sich mit ihrem Absorptionsbereich jeweils vollständig oder größtenteils in einem Volumen (11) erstrecken, das einen zentralen Bereich (112) des Pixels umgibt; und
- Bedrucken der Druckschicht zur Bildung der brechenden Strukturen (131; 531; 631; 731) unter Verwendung einer Siliziumform (90), die gegen die Druckschicht gedrückt wird.

**Claims**

1. A photo-detection device including a pixel array, wherein the pixels (100; 500; 600; 700) each comprise a photodiode (815A; 815B) the absorption region of which totally or mostly extends in a volume (111) surrounding a central region (112) of the pixel,

   - each pixel further includes a focusing element, to focus on the corresponding absorption region (819A; 817B) a light beam impinging at a substantially normal incidence on said pixel;
   - the focusing elements consist of an assembly of refractive structures (131; 531; 631; 731), **characterised in that**:
   each refractive structure being formed by a first truncated pyramid (133) and provided with a recess (132), said first pyramid having its base (133A) which is parallel to the plane of the pixel array and located on the side of the photodiodes, and the recess (132) having the shape of a second entire or truncated pyramid (134) the base (132A) of which extends parallel to the plane of pixel array on the side of the refractive structure opposite to the photodiodes; and
   - the angles at the base $\varphi_i$ of the first pyramids and second pyramids each satisfy:

   [Math 15]

   $$2 * \varphi_l - \sin^{-1}\left(\frac{n_0}{n_1}\sin(\varphi_l)\right) < \frac{\pi}{2}$$

   with $n_0$ being the optical index of a surrounding medium surrounding the refractive structures (131; 531; 631; 731) on the side opposite to the photodiodes, and $n_1$ being an optical index of said refractive structures.

2. The device according to claim 1, **characterised in that** a height h of each of said refractive structures (131; 531; 631; 731) satisfies:

   [Math 16]

   $$h \geq \frac{\lambda_{moy}}{2n_1}$$

   with $n_1$ being the optical index of said refractive structures (131; 531; 631; 731) and $\lambda_{moy}$ being the central wavelength of a detection spectral range of the photodetection device.

3. The device according to claim 1 or 2, **characterised in that** the angles at the base of each of said first pyramids and second pyramids are each between 50° and 60°.

4. The device according to any of claims 1 to 3, **characterised in that** the optical index of said refractive structures (131; 531; 631; 731) is lower than or equal to 1.7.

5. The device according to any of claims 1 to 4, **characterised in that** in each refractive structure (131; 531; 631; 731), the side faces ($132_1$; $532_1$; $632_1$) of the second pyramid are parallel two by two to the side faces ($131_1$; $531_1$; $631_1$) of the first pyramid.

6. The device according to any of claims 1 to 5, **characterised in that** in each refractive structure (131; 531; 631; 731), the first pyramid is truncated along a plane parallel to the plane of the pixel array.

7. The device according to any of claims 1 to 6, **characterised in that** in each refractive structure (131; 531; 631; 731), the recess (132) has the shape of a second entire pyramid which extends to the base (133A) of the first truncated pyramid.

8. The device according to any of claims 1 to 7, **characterised in that** in each refractive structure (131; 731), the side faces ($131_1$) of the first truncated pyramid and the side faces ($132_1$) of the recess join two by two on the side opposite to the photodiodes.

9. The device according to any of claims 1 to 7, **characterised in that** in the at least one of the refractive structures (531; 631), the side faces ($531_1$; $631_1$) of the first truncated pyramid and the side faces ($532_1$; $632_1$) of the recess are separated two by two by an upper surface ($531_3$; $631_3$) of the refractive structure, on the side opposite to the photodiodes.

10. The device according to any of claims 1 to 9, **characterised in that** each refractive structure (131; 531; 731) extends over a single pixel.

11. The device according to claim 10, **characterised in that** in the at least one of the refractive structures (531), the side faces ($531_1$) of the first truncated pyramid and the side faces ($532_1$) of the recess are separated two by two by an upper surface ($531_3$) of the refractive structure located on the side opposite to the photodiodes, and **in that** each point of said upper surface ($531_3$) is spaced apart from the lower face (533A) of the refractive structure, by a distance $d_1(x, y)$ greater than or equal to $d_{1\_lim}$ and also substantially equal to $d_{1\_lim}$ to within 10%, with:

[Math 17]

$$d_{1\_lim} = \frac{P}{4} * \frac{\tan(\varphi_j)}{1 + \tan(\varphi_j) * \tan(\varphi_j - \theta)}$$

with P being a pixel pitch of the pixel array;
$\varphi_j$ being an angle at the base of said first pyramid; and
$\theta$ being the angle of refraction, in the refractive structure (531) of a light beam impinging at the normal incidence on the pixel array.

12. The device according to any of claims 1 to 9, **characterised in that** each refractive structure (631) extends astride several neighbouring pixels (600).

13. The device according to claim 12, **characterised in that** in the at least one of the refractive structures (631), the side faces ($631_1$) of the first truncated pyramid and the side faces ($632_1$) of the recess are separated two by two by an upper surface ($631_3$) of the refractive structure located on the side opposite to the photodiodes, and **in that** each point of said upper surface ($631_3$) is spaced apart from the lower face (633A) of the refractive structure, by a distance $d_2(x, y)$ strictly smaller than:

[Math 18]

$$\frac{P}{2} * \frac{\tan(\varphi_j)}{1 + \tan(\varphi_j) * \tan(\varphi_j - \theta)}$$

with P being a pixel pitch of the pixel array;
$\varphi_j$ being an angle at the base of said first pyramid; and
$\theta$ being the refraction angle, in the refractive structure (631), of a light beam impinging at the normal incidence on the pixel array.

14. The device according to any of claims 1 to 13, **characterised in that** it includes an antireflection layer (120) between the refractive structures (131; 531; 631; 731) and the photodiodes.

15. A method for making a device according to any of claims 1 to 14, wherein the angles ($\varphi$) at the base of the first pyramids and second pyramids are each between 50° and 60°, the method being **characterised in that** it includes the following steps of:

- depositing a printing layer so as to cover a photodiode array, said photodiodes each having their absorption region which totally or mostly extends in a volume (11) surrounding a central region (112) of the pixel; and
- printing the printing layer to form the refractive structures (131; 531; 631; 731), by using a silicon mould (90) which is pressed against the printing layer.

[Fig. 1A]

1/4

FIG.1A

[Fig. 1B]

FIG.1B

[Fig. 2]

FIG.2

[Fig. 3]

FIG.3

[Fig. 4]

FIG.4

[Fig. 5A]

FIG.5A

[Fig. 5B]

FIG.5B

[Fig. 6A]

FIG.6A

[Fig. 6B]

FIG.6B

[Fig. 7]

FIG.7

[Fig. 8A]

FIG.8A

[Fig. 8B]

FIG.8B

[Fig. 9]

FIG.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2983352

- US 2012273907 A

**Littérature non-brevet citée dans la description**

- **SCHAAKE H. F.** High Operating Temperature MWIR detectors. *Proceedings of SPIE,* Janvier 2010, vol. 7608